# EUROPEAN PATENT APPLICATION

(11) **EP 4 835 953 A1**
(43) Date of publication of application: **04.11.2026**
(21) Application number: 23963058.5
(22) Date of filing: 26.12.2023
(51) Int. Cl.: H01L 21/285, C23C 16/08, C23C 16/455, C23C 16/52, H01L 21/28, H01L 21/3205, H01L 21/768, H01L 23/532

(54) **SUBSTRATE PROCESSING METHOD, METHOD FOR MANUFACTURING SEMICONDUCTOR DEVICE, PROGRAM, AND SUBSTRATE PROCESSING DEVICE**

(71) Applicant: Kokusai Electric Corporation, Tokyo 100-0004 (JP)
(72) Inventor: MATSUNO, Yutaka, Toyama-shi, Toyama 939-2393 (JP); SEINO, Atsuro, Toyama-shi, Toyama 939-2393 (JP); OGAWA, Arito, Toyama-shi, Toyama 939-2393 (JP)
(74) Representative: Bardehle Pagenberg Partnerschaft mbB Patentanwälte Rechtsanwälte
(86) International application number: PCT/JP2023/046691
(87) International publication number: WO 2025/141704

(57) **Abstract**

Provided is a technique with which it is possible to control the orientation of crystal particles in a film (or in a layer). The method includes a step for forming a film on a substrate by performing a cycle for forming layers on the substrate a prescribed number of times by performing (a) a step for supplying a raw material gas containing a halogen element to the substrate, and (b) a step for supplying a reaction gas to the substrate, the cycles being performed under a prescribed formation condition on the basis of a prescribed relationship between the amount of the halogen element included in the layer and the proportion of the film occupied by crystal particles oriented in a prescribed crystal plane.

## Description

### TECHNICAL FIELD

The present disclosure relates to a method of processing a substrate, a method of manufacturing a semiconductor device, a program, and a substrate processing apparatus.

### BACKGROUND

As a process of processing a substrate (a process of manufacturing a semiconductor device), a film may be formed on the substrate by a process of supplying a precursor gas containing a halogen element and a reaction gas to the substrate (for example, *see* Patent Document 1).

### [Prior Art Document]

### Patent Document

Patent Document 1: International Publication No. 2019/058608

### SUMMARY

The present disclosure provides a technique capable of controlling orientation of crystallites in a film (or a layer).

According to some embodiments of the present disclosure, there is provided a technique that includes: forming a film on a substrate by performing a cycle a predetermined number of times, the cycle including: forming a layer on the substrate by performing a process, which includes: (a) supplying a precursor gas containing a halogen element to the substrate; and (b) supplying a reaction gas to the substrate, wherein the cycle is performed under a formation condition set based on a predetermined relationship between an amount of the halogen element contained in the layer and a proportion of crystallites oriented in a predetermined crystal plane in the film.

According to the present disclosure, it becomes possible to control orientation of the crystallites in a film (or a layer).

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view schematically showing a substrate processing apparatus.
FIG. 2 is a schematic configuration diagram of a controller of a substrate processing apparatus, and is a diagram illustrating a control system of the controller in a block diagram.
FIG. 3 is a diagram illustrating timing of gas supply in a substrate processing process.
FIG. 4A is an image diagram of a film (or a layer) formed on a substrate under such a condition that an amount of a halogen element contained in the layer is increased. FIG. 4B is an image diagram of a film (or a layer) formed on a substrate under such a condition that an amount of a halogen element contained in the layer is decreased.
FIG. 5 is a view showing timing of gas supply in a first modification.
FIG. 6 is a diagram for explaining timing of gas supply in first cycles of second and third modifications.
FIG. 7 is a diagram illustrating a flow of the second modification.
FIG. 8 is a diagram illustrating a flow of the third modification.

### DETAILED DESCRIPTION

### <Some Embodiments of the present disclosure>

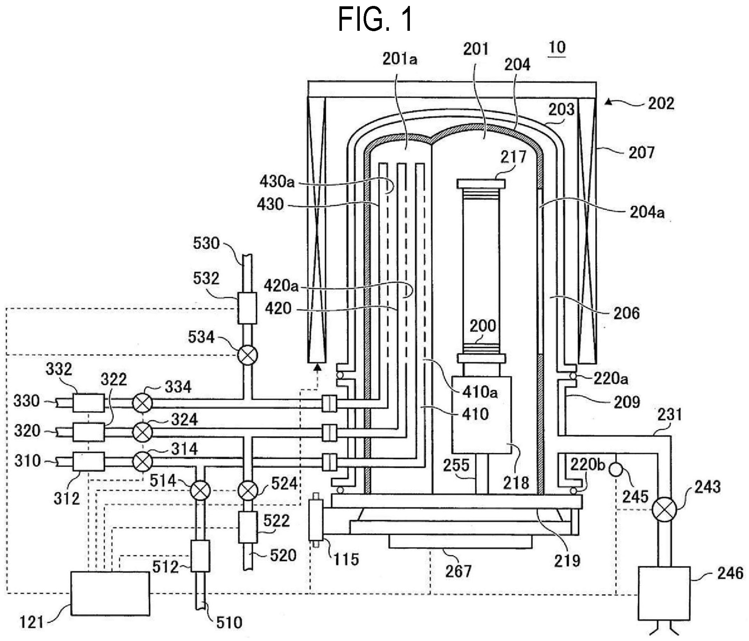

Hereinafter, some embodiments of the present disclosure will be described mainly with reference to FIGS. 1 to 4B. Drawings used in the following description are schematic, and dimensional relationships, ratios, and the like among various components shown in the drawings may not match actual ones. Further, dimensional relationship, ratios, and the like of various components among a plurality of drawings may not match one another.

### (1) Configuration of Substrate Processing Apparatus

A substrate processing apparatus 10 includes a process furnace 202 provided with a heater 207 as a heating means or unit (a heating mechanism or a heating system). An outer tube 203 is disposed inside the heater 207. An O-ring 220a as a seal and a manifold 209 are disposed below the outer tube 203. An inner tube 204 is disposed inside the outer tube 203. A processing container (a reaction vessel) is constituted by the outer tube 203, the inner tube 204, and the manifold 209. A process chamber 201 is formed inside the inner tube 204.

Nozzles 410, 420, and 430 are installed in the process chamber 201. Gas supply pipes 310, 320, and 330 are connected to the nozzles 410, 420, and 430, respectively.

Vertical portions of the nozzles 410, 420, and 430 are installed in a preliminary chamber 201a formed to protrude radially outward from the inner tube 204. At the nozzles 410, 420, and 430, a plurality of gas supply holes 410a, 420a, and 430a are provided. The gas supplied to the nozzles 410, 420, and 430 is supplied from each of the gas supply holes 410a, 420a, and 430a into the process chamber 201 and/or to a wafer 200.

A precursor gas containing a halogen element as a processing gas is supplied into the process chamber 201 via a mass flow controller (MFC) 312, which is a flow rate controller (a flow rate control part), a valve 314, and the nozzle 410, which are installed at the gas supply pipe 310 sequentially. A reducing gas as a processing gas is supplied into the process chamber 201 via a MFC 322, a valve 324, and the nozzle 420, which are installed at the gas supply pipe 320 sequentially. A reaction gas as a processing gas is supplied into the process chamber 201 via a MFC 332, a valve 334, and the nozzle 430, which are installed at the gas supply pipe 330 sequentially.

Gas supply pipes 510, 520, and 530 are connected to the gas supply pipes 310, 320, and 330 at the downstream sides of the valves 314, 324, and 334, respectively. An inert gas is supplied into the process chamber 201 via MFCs 512, 522, and 532, valves 514, 524, and 534, and the nozzles 410, 420, and 430, which are installed at the gas supply pipes 510, 520, and 530 respectively.

A processing gas supply system is mainly constituted by the gas supply pipes 310, 320, and 330, the MFCs 312, 322, and 332, the valves 314, 324, and 334, and the nozzles 410, 420, and 430. The nozzles 410, 420, and 430 may be considered as the processing gas supply system. Further, the processing gas supply system may be simply referred to as a gas supply system. In a case where the precursor gas flows mainly from the gas supply pipe 310, a precursor gas supply system is constituted by the gas supply pipe 310, the MFC 312, and the valve 314. The nozzle 410 may be included in the precursor gas supply system. Further, in a case where the reducing gas flows mainly from the gas supply pipe 320, a reducing gas supply system is constituted by the gas supply pipe 320, the MFC 322, and the valve 324. The nozzle 420 may be included in the reducing gas supply system. In addition, in a case where the reaction gas flows mainly from the gas supply pipe 330, a reaction gas supply system is configured by the gas supply pipe 330, the MFC 332, and the valve 334. The nozzle 430 may be included in the reaction gas supply system. An inert gas supply system is mainly constituted by the gas supply pipes 510, 520, and 530, the MFCs 512, 522, and 532, and the valves 514, 524, and 534.

An exhaust hole (an exhaust port) 204a is a through-hole formed in a side wall of the inner tube 204. The gas supplied into the process chamber 201 flows over the wafer 200 in the horizontal direction, and is then discharged from the process furnace 202 via the exhaust hole 204a, an exhaust path 206 formed between the inner tube 204 and the outer tube 203, and the exhaust pipe 231 sequentially.

A pressure sensor 245 as a pressure detector (a pressure detecting part) configured to detect an internal pressure of the process chamber 201, an auto pressure controller (APC) valve 243, and a vacuum pump 246 as a vacuum exhauster are connected to the exhaust pipe 231 sequentially from the upstream side. The APC valve 243 can perform or stop a vacuum exhausting operation of an interior of the process chamber 201 by being opened or closed while the vacuum pump 246 is actuated. Further, the APC valve 243 can regulate the internal pressure of the process chamber 201 by adjusting a degree of valve opening while the vacuum pump 246 is actuated. An exhaust system is mainly constituted by the exhaust hole 204a, the exhaust path 206, the exhaust pipe 231, the APC valve 243, and the pressure sensor 245. The vacuum pump 246 may be included in the exhaust system.

An O-ring 220b as a seal and a seal cap 219 capable of airtightly closing a lower end opening of the manifold 209 are installed below the manifold 209. A rotator 267 configured to rotate the boat 217 and the wafer 200 by rotating a rotary shaft 255 is installed at the seal cap 219. A boat elevator 115 as an elevating mechanism is configured to be capable of loading or unloading the boat 217 into or out of the process chamber 201 by raising or lowering the seal cap 219.

The boat 217 serving as a substrate support is configured to support a plurality of wafers 200, for example, 25 to 200 wafers in a horizontal posture. A heat insulating cylinder 218 is installed at a lower side of the boat 217. In the present disclosure, notation of a numerical range such as "25 to 200 sheets" means that a lower limit value and an upper limit value are included in that range. Thus, for example, "25 to 200 sheets" means "25 or more and 200 sheets or less." The same applies to other numerical ranges.

A temperature sensor 263 as a temperature detector is installed in the inner tube 204. Based on temperature information detected by the temperature sensor 263, a state of supplying electric power to the heater 207 is regulated such that a temperature distribution in the process chamber 201 becomes a desired temperature distribution.

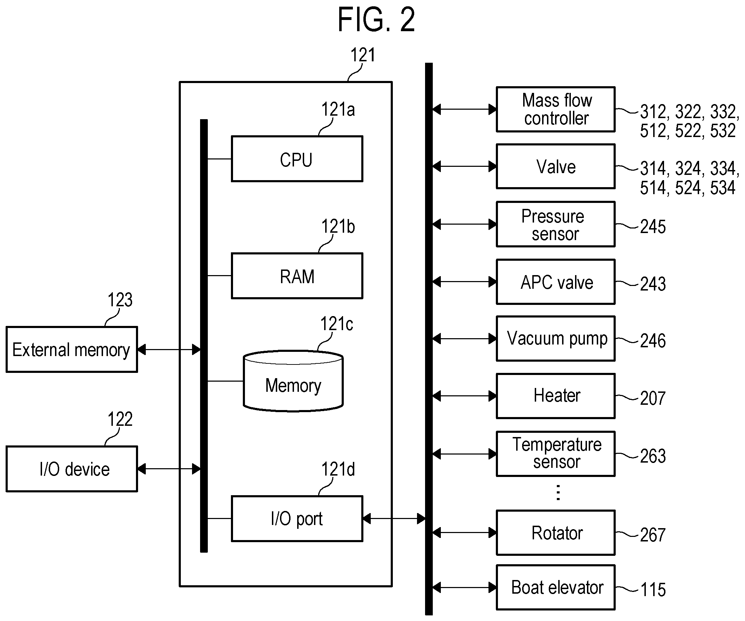

As shown in FIG. 2, the controller 121 as a control part (control means or unit) is constituted as a computer including a central processing unit (CPU) 121a, a random access memory (RAM) 121b, a memory 121c and an I/O port 121d. The RAM 121b, the memory 121c, and the I/O port 121d are configured to be capable of exchanging data with the CPU 121a via an internal bus. An input/output device 122 constituted as, for example, a touch panel or the like is connected to the controller 121.

The memory 121c includes, for example, a flash memory, a hard disk drive (HDD), or the like. A control program that controls operations of a substrate processing apparatus, a process recipe in which sequences and conditions of a method of processing a substrate or a method manufacturing a semiconductor device to be described below are written, and the like are readably stored in the memory 121c. The process recipe functions as a program combined to cause the controller 121 to perform each process (each step) in the method of manufacturing the semiconductor device to be described below so as to obtain an expected result. Hereinafter, the process recipe and the control program may be generally and simply referred to as a "program." When the term "program" is used herein, it may indicate a case of including the process recipe, a case of including the control program, or a case of including both the process recipe and the control program. The RAM 121b is constituted as a memory area (work area) in which programs or data read by the CPU 121a are temporarily stored.

The I/O port 121d is connected to the MFCs 312, 322, 332, 512, 522, and 532, the valves 314, 324, 334, 514, 524, and 534, the pressure sensor 245, the APC valve 243, the vacuum pump 246, the heater 207, the temperature sensor 263, the rotator 267, the boat elevator 115, and the like.

The CPU 121a is configured to read and execute the control program from the memory 121c. The CPU 121a is also configured to read the recipe from the memory 121c according to an input of an operation command from the input/output device 122, or the like. The CPU 121a is configured to control flow rate regulating operations of various gases by the MFCs 312, 322, 332, 512, 522, and 532), opening/closing operations of the valves 314, 324, 334, 514, 524, and 534, an opening/closing operation of the APC valve 243 and a pressure regulating operation performed by the APC valve 243 based on the pressure sensor 245, a temperature regulating operation performed by the heater 207 based on the temperature sensor 263, an actuating or stopping operation of the vacuum pump 246, operations of rotating the boat 217 and adjusting a rotation speed of the boat 217 with the rotator 267, an operation of raising or lowering the boat 217 by the boat elevator 115, an operation of loading the wafer 200 into the boat 217, and so on, according to contents of the read recipe.

The controller 121 may be constituted by installing, in the computer, the above-described program stored in the external memory (for example, a magnetic disk such as a magnetic tape, a flexible disk, or a hard disk, an optical disc such as a CD or DVD, a magneto-optical disc such as a MO, or a semiconductor memory such as a USB memory or a memory card) 123. The memory 121c or the external memory 123 is constituted as a computer-readable recording medium recording a program. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. Furthermore, the program may be provided to the computer by using communication means or unit such as the Internet or a dedicated line, instead of using the external memory 123.

### (2) Process of Processing Substrate (Film Formation Process)

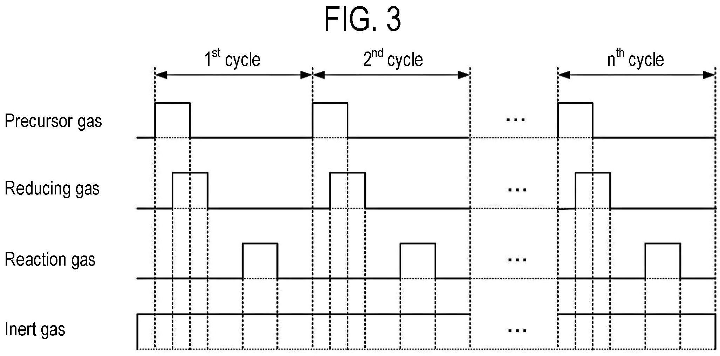

An example of a process of forming a predetermined film on the wafer 200 as a process of manufacturing a semiconductor device (device) will be described with reference to FIG. 3. In the following description, an operation of each component constituting the substrate processing apparatus 10 is controlled by the controller 121.

In the present disclosure, the process of processing the substrate shown in FIG. 3 may be shown as follows for convenience. The same notation is also used in the following description of modifications. 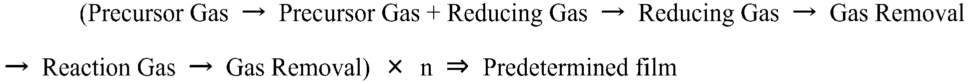 (Precursor Gas → Precursor Gas + Reducing Gas → Reducing Gas → Gas Removal → Reaction Gas → Gas Removal) × n ⇒ Predetermined film

The term "wafer" used herein may refer to a wafer itself or a stacked body of a wafer and a predetermined layer or film formed on a surface of the wafer. The phrase "a surface of a wafer" used herein may refer to a surface of a wafer itself or a surface of a predetermined layer or the like formed on a wafer. The expression "a predetermined layer is formed on a wafer" used herein may mean that a predetermined layer is directly formed on a surface of a wafer itself or that a predetermined layer is formed on a layer or the like formed on a wafer. The term "substrate" used herein may be synonymous with the term "wafer."

### (Wafer Loading)

A plurality of wafers 200 are charged into the boat 217. Thereafter, the boat 217 supporting the plurality of wafers 200 is lifted by the boat elevator 115 and loaded into the process chamber 201. As shown in FIG. 1, the seal cap 219 is brought into a state in which a lower end opening of the outer tube 203 is closed.

### (Pressure Regulation and Temperature Regulation)

The interior of the process chamber 201 is vacuum-exhausted by the vacuum pump 246 to reach a desired pressure (degree of vacuum). In this operation, the internal pressure of the process chamber 201 is measured by the pressure sensor 245, and the APC valve 243 is feedback-controlled based on the measured pressure information (pressure regulation). Further, the interior of the process chamber 201 is heated by the heater 207 to reach a desired temperature. Further, rotation (rotation operation) of the boat 217 and the wafer 200 by the rotator 267 is started. The exhaust and rotation operations are continuously performed at least until the processing on the wafer 200 is completed.

### (Supply of Precursor Gas, step S11)

The valves 314 and 514 are opened to allow a precursor gas containing a halogen element through the gas supply pipe 310 and an inert gas to flow through the gas supply pipe 510, respectively. The precursor gas and the inert gas are supplied from the gas supply hole 410a of the nozzle 410 into the process chamber 201 and to the wafer 200, and are exhausted via the exhaust pipe 231. In this operation, the valves 524 and 534 are opened to allow the inert gas to flow through the gas supply pipes 520 and 530 so as to prevent ingress of precursor gas into the nozzles 420 and 430.

Processing conditions when the precursor gas is supplied in this step are exemplified as follows:
Processing temperature: 300 to 600 degrees C, specifically 400 to 560 degrees C, more specifically 450 to 530 degrees C
Processing pressure: 1 to 3,990 Pa
Supply flow rate of precursor gas: 0.1 to 2.0 slm
Supply flow rate of inert gas (for each nozzle): 0.1 to 20 slm

Further, from the viewpoint of improving a processing speed, specifically, the processing temperature may be set to substantially the same temperature in any step.

The processing temperature in the present disclosure means a temperature of the wafer 200 or an internal temperature of the process chamber 201, and the processing pressure means an internal pressure of the process chamber 201. Further, the processing time means the time during which a processing is continued. The same applies to the following description.

By the supply of the precursor gas, a layer A containing a predetermined element and a halogen element is formed on the wafer 200 (a base film of the surface). Further, in the following description, in addition to the term "layer A," the term "modified layer" is used. The term "layer" in the present disclosure may be used as a generic term for the layer A and the modification layer, or may be used as one of the layer A and the modification layer.

As the precursor gas, a gas containing a predetermined element and a halogen element may be used. As the predetermined element, for example, one or more of tungsten (W), titanium (Ti), molybdenum (Mo), tantalum (Ta), cobalt (Co), yttrium (Y), ruthenium (Ru), hafnium (Hf), zirconium (Zr), aluminum (Al), silicon (Si), and the like may be used. As the halogen element, one or more of fluorine (F), chlorine (Cl), and the like may be used. As the precursor gas, a gas activated by plasma or the like may be used.

As the gas containing the predetermined element and the halogen element, for example, a gas containing tungsten hexachloride (WCl₆), tungsten hexafluoride (WF₆), titanium tetrachloride (TiCl₄), titanium tetrafluoride (TiF₄), molybdenum pentachloride (MoCl₅), molybdenum pentafluoride (MoF₅), molybdenum dichlorodioxide (MoO₂Cl₂), molybdenum tetrachloride (MoOCl₄), tantalum pentachloride (TaCl₅), tantalum pentafluoride (TaF₅), cobalt difluoride (CoF₂), cobalt dichloride (CoCl₂), yttrium trifluoride (YF₃), yttrium trichloride (YCl₃), ruthenium trichloride (RuCl₃), ruthenium trifluoride (RuF₃), hafnium tetrachloride (HfCl₄), hafnium tetrafluoride (HfF₄), zirconium tetrachloride (ZrCl₄), zirconium tetrafluoride (ZrF₄), aluminum trichloride (AlCl₃), aluminum trifluoride (AlF₃), dichlorosilane (SiH₂Cl₂), 1,2-dichlorodisilane (Si₂H₄Cl₂), 1,1,1-trichlorodisilane (Si₂H₃Cl₃), 1,1,2-trichlorodisilane (Si₂H₃Cl₃), pentachlorodisilane (Si₂HCl₅), hexachlorodisilane (Si₂Cl₆), tetrafluorosilane (SiF₄), or the like may be used. As the precursor gas, one or more of these may be used.

As the inert gas, for example, a rare gas such as an argon (Ar) gas, a helium (He) gas, a neon (Ne) gas, or a xenon (Xe) gas may be used in addition to a nitrogen (N₂) gas. As the inert gas, one or more of these may be used. As the inert gas, the same applies to the following description.

### (Simultaneous supply of precursor gas and reducing gas, step S12)

After a predetermined time elapses from the start of the supply of the precursor gas, for example, 0.01 to 5 seconds later, the valves 324 and 524 are opened, such that the reducing gas flows through the gas supply pipe 320, and the inert gas flows through the gas supply pipe 520, respectively. The reducing gas and the inert gas are supplied into the process chamber 201 from the gas supply hole 420a of the nozzle 420 respectively, and are exhausted via the exhaust pipe 231. Here, the supply of the precursor gas into the process chamber 201 is continuously performed from step S11. That is, the supply of the reducing gas is performed at least partially at the same time as the supply of the precursor gas. In other words, the precursor gas and the reducing gas are supplied to the wafer 200 at the same time. In this operation, the valve 534 is opened to allow the inert gas to flow through the gas supply pipe 530 so as to prevent ingress of the precursor gas and the reducing gas into the nozzle 430.

By supplying the reducing gas, at least a portion of the halogen element contained in the layer may be removed. Further, by-products containing a halogen element before being adsorbed on the wafer 200 may be reduced and removed from the process chamber 201. Thus, an amount of the halogen element contained in the layer may be controlled. In addition, inhibition of formation of a layer due to the by-products adsorbed on the wafer 200 may be suppressed, and a deposition rate may be improved.

Further, by simultaneous supply of the precursor gas and the reducing gas, the amount in which the by-products containing the halogen element are adsorbed on the wafer 200 may be reduced. Therefore, the deposition rate can be further improved.

Processing conditions when the precursor gas and the reducing gas are supplied in this step are exemplified as follows:
Processing pressure: 130 to 3,990 Pa
Supply flow rate of reducing gas: 0.1 to 5 slm
Supply flow rate of inert gas (for each nozzle): 0.01 to 20 slm

Other processing conditions may be the same as those when the precursor gas is supplied. This step is performed for, for example, 0 to 10 seconds.

As the reducing gas, a gas that does not contain main constituent elements of the film may be used. In this case, it is difficult for a reaction between a precursor gas and a reducing gas or a reaction between a reaction gas and the reducing gas to occur. For this reason, the supply of the reducing gas may be started before the precursor gas or the reaction gas is sufficiently removed from the process chamber 201. Thus, an increase in processing time can be suppressed.

As the reducing gas, for example, one or more of hydrogen (H₂) gas, deuterium (D₂) gas, borane (BH₃) gas, diborane (B₂H₆) gas, carbon monoxide (CO) gas, ammonia (NH₃) gas, monosilane (SiH₄) gas, disilane (Si₂H₆) gas, trisilane (Si₃H₈) gas, mono germane (GeH₄) gas, digermane (Ge₂H₆) gas, trimethylaluminum ((CH₃)₃Al) gas, phosphine (PH₃) gas, and the like may be used.

### (Supply of Reducing Gas, step S13)

After the supply of the precursor gas is started, for example, 0.01 to 10 seconds later and before the end of the supply of the reducing gas, the valve 314 of the gas supply pipe 310 is closed to stop the supply of the precursor gas. In this operation, the reducing gas is supplied to the wafer 200. At this time, the valves 514 and 534 are opened to allow the inert gas to flow through the gas supply pipes 510 and 530 so as to prevent ingress of the reducing gas into the nozzles 410 and 430.

The halogen element contained in the layer may be further removed by the supply of the reducing gas after the supply of the precursor gas is stopped. Thus, the amount of the halogen element contained in the layer can be controlled. In addition, inhibition of formation of the layer due to the by-products adsorbed on the wafer 200 can be suppressed, and the deposition rate can be improved.

### (Remaining gas removal, step S14)

After the supply of the reducing gas is started, for example, 0.01 to 10 seconds later and after the end of the supply of the precursor gas, the valve 324 is closed to stop the supply of the reducing gas. In this operation, the APC valve 243 of the exhaust pipe 231 is left open, such that the interior of the process chamber 201 is vacuum-exhausted by the vacuum pump 246. Thereby, gas removal is performed in a space in which the wafer 200 exists. In this operation, the valves 514, 524, and 534 may be left open to maintain supply of the inert gas into the process chamber 201. The inert gas acts as a purge gas, such that the gas removal in the process chamber 201 can be efficiently performed.

### (Supply of Reaction Gas, step S15)

Then, the valves 334 and 534 are opened to allow the reaction gas to flow through the gas supply pipe 330 and the inert gas to flow through the gas supply pipe 530, respectively. The reaction gas and the inert gas are supplied into the process chamber 201 from the gas supply hole 430a of the nozzle 430, and are exhausted via the exhaust pipe 231. In this operation, the reaction gas is supplied to the wafer 200. At this time, the valves 514 and 524 are opened to allow the inert gas to flow through the gas supply pipes 510 and 520 to prevent ingress of the reaction gas into the nozzles 410 and 420. The reaction gas reacts with at least a portion of the layer A on the wafer 200 to form a modification layer. In other words, the reaction gas modifies at least a portion of the layer A on the wafer 200 to form the modification layer.

Processing conditions when the reaction gas is supplied in this step are exemplified as follows:
Processing pressure: 1 to 3,990 Pa
Supply flow rate of reaction gas: 0.1 to 30 slm
Supply time of reaction gas: 0.01 to 30 seconds
Supply flow rate of inert gas (for each nozzle): 0.1 to 30 slm

Other processing conditions may be the same as those when the precursor gas is supplied.

As the reaction gas, for example, a gas including the above-described reducing gas, an oxidizing gas containing oxygen (O), a nitriding gas containing nitrogen (N), a sulfiding gas, a seleniding gas, a telluriding gas, or the like may be used. As the reaction gas, one or more of these may be used. As the reaction gas, a gas activated by plasma or the like may be used. For example, in a case where the reaction gas is used as the reducing gas, a film mainly constituted by the above-described predetermined element in its elemental form may be formed on the wafer 200. Further, for example, in a case where any one of the oxidizing gas, the nitriding gas, the sulfiding gas, the seleniding gas, and the telluriding gas is used as the reaction gas, any one of an oxide film, a nitride film, a sulfide film, a selenide film, and a telluride film containing the above-described predetermined element may be formed on the wafer 200.

As the oxidizing gas, for example, one or more gases containing oxygen (O₂), ozone (O₃), water vapor (H₂O), a mixture of H₂ and O₂, hydrogen peroxide (H₂O₂), nitrous oxide (N₂O), or the like may be used. As the nitriding gas, for example, one or more of hydrogen nitride-based gases such as an ammonia (NH₃) gas, a diazene (N₂H₂) gas, a hydrazine (N₂H₄) gas, and a N₃H₈ gas may be used. As the sulfiding gas, for example, one or more gases containing sulfane (H₂S), disulfane (H₂S₂), diammonium sulfide ((NH₄)₂S), dimethyl sulfide ((CH₃)₂S), or the like may be used. As the seleniding gas, for example, one or more gases containing selane (H₂Se), diselane (H₂Se₂), dimethyl selenide ((CH₃)₂Se), or the like may be used. As the telluriding gas, for example, one or more gases containing tellane (H₂Te), ditellane (H₂Te₂), dimethyl selenide ((CH₃)₂Te), or the like may be used.

### (Remaining gas removal, step S16)

After the supply of the reaction gas is started, for example, 0.01 to 60 seconds later, the valve 334 is closed to stop the supply of the reaction gas. Then, gas removal in the space in which the wafer 200 exists is performed by the processing sequence similar to that in step S14 described above.

### (Performing predetermined number of times, step S17)

By performing a cycle of forming the layer on the wafer 200 according to the above-described steps S11 to S16 a predetermined number of times (n times, n is 1 or an integer of 2 or more), a film with a predetermined thickness is formed on the wafer 200. As the film, for example, a TiN film which is a film mainly constituted by titanium nitride (TiN) is formed. In this case, for example, a tungsten (W) film may be used for a control gate of a NAND flash memory, and a TiN film may be formed as a barrier film between the W film and an insulating film. This TiN film serves to increase adhesion between the W film and the insulating film.

In general, as a temperature at the time of forming a film increases, a proportion of crystallites oriented in a predetermined crystal plane to the entirety of crystallites in the film tends to increase. For example, as a temperature at the time of forming the TiN film increases, a proportion of crystallites oriented in a predetermined crystal plane (for example, in the case of the TiN film, a {111} plane in a crystal lattice of TiN) increases. In this case, a phrase "a proportion of crystallites oriented in a predetermined crystal plane (for example, the {111} plane) is high" may also be referred to as "a degree of orientation in a predetermined crystal plane is high." Further, the "crystallites oriented in a predetermined crystal plane" are "crystallites which are grown toward the predetermined crystal surface in a direction perpendicular to the surface of the wafer 200."

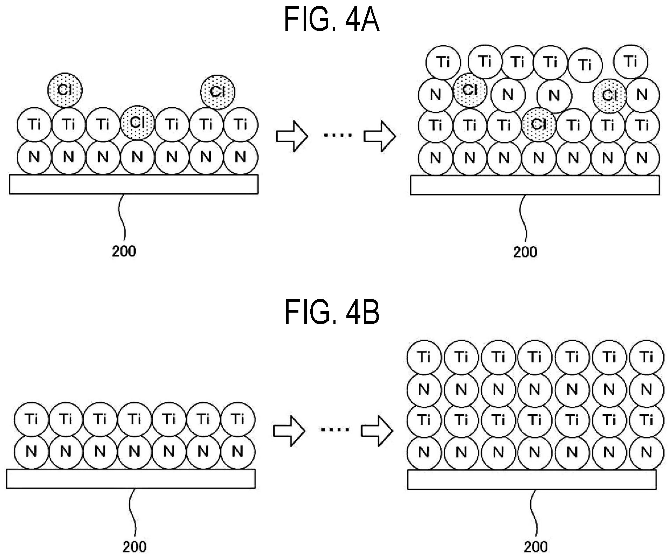

In this case, an example in which a TiN layer and a TiN film are formed on the wafer 200 by using a precursor gas, which contains Ti as a predetermined element and Cl as a halogen element, and a reaction gas as a nitriding gas will be considered. In such a case, a Ti-Cl bond in a molecular structure of the precursor gas, a N-Cl bond generated by adsorption of a by-product such as a halide (e.g., HCl) on the layer, or the like may remain in the TiN layer. FIG. 4A is an image diagram when a TiN film (or a TiN layer) is formed on the wafer 200 under such a condition that an amount of Cl contained in the TiN layer is increased. FIG. 4B is an image diagram when a TiN film (or a TiN layer) is formed on the wafer 200 under such a condition that an amount of Cl contained in the TiN layer is decreased.

As shown in FIG. 4B, when the amount of the halogen element contained in the TiN layer is small, the number of TiN crystallites with disordered atomic arrangement decreases. As a result, since the crystallites of TiN are easily aligned, the orientation in the {111} plane is likely to be increased. In a TiN film with an increased orientation in the {111} plane, gaps are likely to be formed between TiN crystallites. For this reason, oxygen or moisture in the atmosphere, various processing liquids or processing gases used in other processes, and the like enter the gaps, which may lead to oxidation of the TiN film or deterioration of a film quality.

In contrast, as shown in FIG. 4A, when the amount of the halogen element contained in the TiN layer is large, the number of the TiN crystallites with disordered atomic arrangement increases. As a result, a proportion of crystallites oriented in planes other than the predetermined crystal plane increases, and thus the degree of orientation of the {111} plane decreases. For this reason, it is difficult for a material which may lead to the oxidation of the TiN film or the deterioration of the film quality to enter between the TiN crystallites, and the film quality is improved.

That is, a relationship is established in which the degree of orientation of the predetermined crystal plane in the film is reduced with an increase in the amount of the halogen element contained in the layer. In other words, it may be said that a predetermined relationship is established between the amount of the halogen element contained in the layer and the proportion of crystallites oriented in the predetermined crystal plane in the film (the orientation of the predetermined crystal plane in the film). Furthermore, it may be said that by performing the above-described cycle under a condition for forming a layer set based on a predetermined relationship (hereinafter referred to as a "formation condition"), the orientation of the predetermined crystal plane in the film (or in the layer) can be controlled.

Next, a setting example of a formation condition such as controlling the amount of the halogen element contained in the layer will be described. In addition, an example of setting the formation condition so as to increase the amount of the halogen element contained in the layer, as compared with a case where a film is formed by using a formation condition different from that for the above-described step of processing the substrate (hereinafter, referred to as a "conventional condition"), will also be described.

For example, at least one selected from the group of an exposure amount of the precursor gas, an exposure amount of the reducing gas, and an exposure amount of the reaction gas during the above-described cycle is controlled to perform the cycle. Thereby, the amount of the halogen element contained in the layer can be controlled.

Specifically, the amount of the halogen element contained in the layer may be made larger than that under the conventional condition by making the exposure amount of the precursor gas larger than that under the conventional condition. In addition, compared to the conventional condition, the exposure amount of the precursor gas can be increased more than that under the conventional condition by at least one selected from the group of lengthening the supply time of the precursor gas, increasing a partial pressure of the precursor gas, increasing the processing pressure during the supply of the precursor gas, increasing a mole fraction of the precursor gas, increasing the supply flow rate of the precursor gas, decreasing the flow rate of the inert gas supplied simultaneously with the precursor gas, and the like in step S11 and/or S12.

Here, the "exposure amount of the precursor gas" is calculated as, for example, "a value obtained by integrating the partial pressure of the precursor gas in the space where the wafer 200 is present in the process of supplying the precursor gas by the time from the start to the end of the supply of the precursor gas (hereinafter, referred to as a "supply time of the precursor gas")." Further, the "partial pressure of the precursor gas" is calculated as, for example, "a value obtained by time-integrating a product of the mole fraction of the precursor gas and the processing pressure in the space in which the wafer 200 is present." The same applies to other gases.

In addition, the amount of the halogen element contained in the layer can be made larger than that under the conventional condition by making the exposure amount of the reducing gas smaller than that under the conventional condition. In addition, compared to the conventional condition, the exposure amount of the reducing gas can be made smaller than that under the conventional condition by at least one selected from the group of shortening the supply time of the reducing gas, lowering the partial pressure of the reducing gas, lowering the processing pressure during the supply of the reducing gas, decreasing the mole fraction of the reducing gas, decreasing the supply flow rate of the reducing gas, decreasing the supply flow rate of the inert gas supplied simultaneously with the precursor gas, and the like in step S12 and/or S13.

In addition, by making the exposure amount of the reaction gas smaller than that under the conventional conditions, the amount of the halogen element contained in the layer can be made larger than that under the conventional condition. Furthermore, compared to the conventional condition, the exposure amount of the reaction gas can be made smaller than that under the conventional condition by controlling at least one selected from the group of shortening the supply time of the reaction gas, lowering the partial pressure of the reaction gas, lowering the processing pressure during the supply of the reaction gas, decreasing the mole fraction of the reaction gas, decreasing the supply flow rate of the reaction gas, increasing the flow rate of the inert gas supplied simultaneously with the reaction gas, and the like in step S15.

Further, the length of step S12 described above, that is, the length of the period in which supply of the precursor gas and supply of the reducing gas are performed at the same time (hereinafter, referred to as a simultaneous supply time) may be controlled to perform the cycle. Thereby, the amount of the halogen element contained in the layer can be controlled. For example, in a case where the simultaneous supply time of the supply of the precursor gas and the supply of the reducing gas is made shorter than that under the conventional condition, the amount of the halogen element contained in the layer can be made larger than that under the conventional condition.

Further, the condition for residual gas removal in one or both of steps S14 and S16 described above may be controlled to perform the cycle. Thereby, the amount of the halogen element contained in the layer can be controlled. Specifically, at least one selected from the group of the time for performing residual gas removal, the processing pressure in the residual gas removal, and the supply flow rate of the purge gas in the residual gas removal may be controlled as the condition for the residual gas removal. Thereby, the amount of the halogen element contained in the layer can be controlled.

Specifically, the amount of the halogen element contained in the layer can be made larger than that under the conventional condition by making the time for performing residual gas removal shorter than that under the conventional condition. Further, the amount of the halogen element contained in the layer can be made larger than that under the conventional condition by making the processing pressure in the residual gas removal higher than that under the conventional condition. Further, by making the supply flow rate of the purge gas in the residual gas removal smaller than that under the conventional condition, the amount of the halogen element contained in the layer can be made larger than that under the conventional condition.

For example, by X-ray Diffraction (XRD) measurement, orientation of the film can be evaluated by comparing an intensity of X-ray diffraction by a predetermined crystal plane with an intensity of X-ray diffraction by one or more other crystal planes. Further, the orientation of the film may be evaluated by a method other than the X-ray diffraction.

For example, two or more films formed by using two or more formation conditions in which the amounts of the halogen elements contained in the layer are different from each other may be evaluated for their respective orientations. Thereby, a predetermined relationship between the amount of the halogen element contained in the layer and the orientation of the predetermined crystal plane in the film can be derived.

In the case where the TiN film is formed, when the processing temperature is less than 300 degrees C, reactivity of the processing gas (the precursor gas, the reaction gas, or the reducing gas) is low, and thus formation of a layer becomes difficult to proceed. When the processing temperature is larger than 600 degrees C, since pyrolysis of the processing gas is likely to proceed, it is difficult to form a TiN film with a uniform thickness in a recess (a trench or a hole) formed on the wafer 200. Therefore, by setting the processing temperature to 300 to 600 degrees C, the TiN film with a uniform thickness can be easily formed while the TiN layer is easily formed.

In addition, since the reactivity of the processing gas is higher by setting the processing temperature to 400 degrees C or more, electrical characteristics of the TiN film can be improved. In a case where the processing temperature is 560 degrees C or less, the pyrolysis of the processing gas becomes more difficult to proceed, such that the TiN film with the uniform thickness in the recess is more likely to be formed. Therefore, when the TiN film is formed, the processing temperature may be set to 400 to 560 degrees C.

In addition, since the reactivity of the processing gas is higher by setting the processing temperature to 450 degrees C or more, the electrical characteristics of the TiN film can be further improved. In addition, when the processing temperature is set to 450 degrees C or more, a decrease in film quality is liable to occur due to increase in the degree of orientation of the {111} plane of the TiN film. Even in such a case, the degree of orientation of the {111} plane of the TiN film can be reduced by using the features in the present disclosure. In a case where the processing temperature is 530 degrees C or less, since the pyrolysis of the processing gas becomes more difficult to proceed, the TiN film with the uniform thickness in the recess is more likely to be formed. Therefore, when the TiN film is formed, the processing temperature may be set to 450 to 530 degrees C.

### (After-Purge and Returning to Atmospheric Pressure)

An inert gas is supplied into the process chamber 201 from each of the gas supply pipes 510, 520, and 530, and is exhausted via the exhaust pipe 231. Thereafter, an internal atmosphere of the process chamber 201 is substituted with the inert gas, and the internal pressure of the process chamber 201 is returned to the normal pressure.

### (Wafer Discharging)

The seal cap 219 is lowered by the boat elevator 115, and the wafer 200 supported by the boat 217 is unloaded to the outside of the process chamber 201. Then, the wafer 200 is discharged from the boat 217.

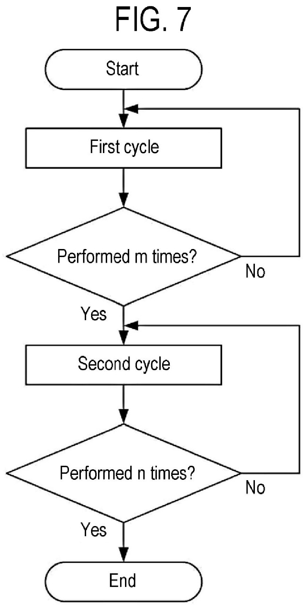

Further, in the above-described substrate processing process, step S12 (simultaneous supply of the precursor gas and the reducing gas) and step S13 (supply of the reducing gas) may be omitted. Specifically, as shown in FIG. 7, a cycle of forming a layer on the wafer 200 by steps S11 and S14 to S16 may be performed a predetermined number of times. Also in this case, at least some of the above-described effects can be obtained.

### (3) Modifications

A substrate processing process in this embodiment is not limited to the embodiment shown in FIG. 3, and may be changed as in modifications shown below.

### (First Modification)

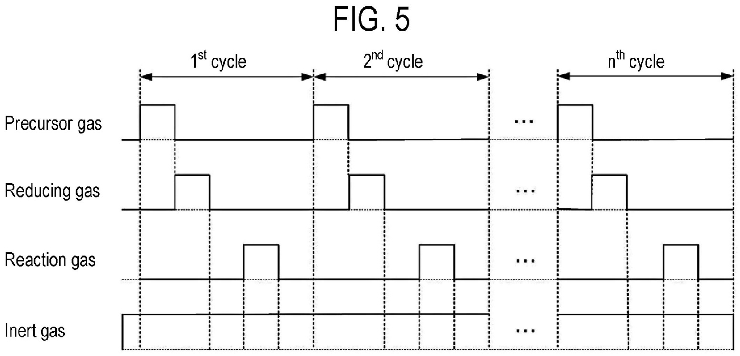

As shown in FIG. 5, this modification differs from the above-described substrate processing process in that the supply of the reducing gas is started at the same time as end of the supply of the precursor gas. The substrate processing process in this modification may be shown as follows. 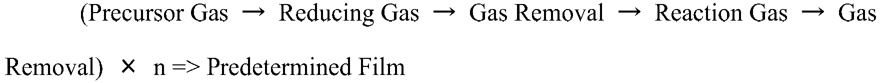 (Precursor Gas → Reducing Gas → Gas Removal → Reaction Gas → Gas Removal) × n => Predetermined Film

Also in this modification, the amount of the halogen element contained in the layer can be controlled, and effects similar to those of the above-described embodiments is obtained. Further, in this modification, the processing time may be made shorter than that in the above-described embodiments, thereby obtaining an improved throughput. In addition, even in a case where gas removal is performed between end of the supply of the precursor gas and start of the supply of the reducing gas, the same effect can be obtained.

### (Second Modification)

In this modification, as shown in FIG. 7, after the first layer is formed under the formation condition in which the amount of the halogen element contained in the layer increases, the second layer is formed under the formation condition in which the amount of the halogen element contained in the layer decreases, thereby forming a film on the wafer 200. That is, in the formation of the film, the formation condition is changed at least once to change the amount of the halogen element contained in the layer.

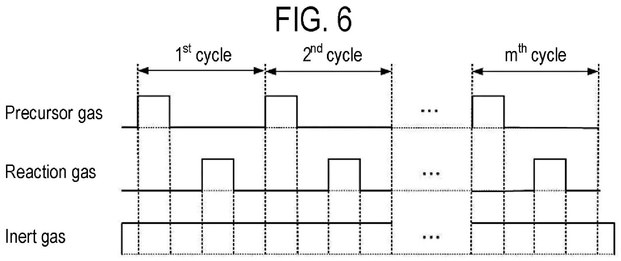

Specifically, as shown in FIG. 6, a first layer is formed by performing a step of performing a cycle (hereinafter, referred to as a "first cycle") including supply of the precursor gas, residual gas removal, supply of the reaction gas, and residual gas removal a predetermined number of times (m times, m is 1 or an integer of 2 or more). Then, the second layer is formed by performing the substrate processing process (hereinafter, referred to as a "second cycle") shown in FIG. 3. Further, even in the same sequence as the first cycle, at least some of the above-described effects can be obtained.

Here, since the first cycle does not include supply of a reducing gas in the second cycle, the amount of the halogen element contained in the first layer is larger than that of the second layer. That is, in this modification, after the first layer with a large content of the halogen element is formed on the wafer 200, the second layer with a small content of the halogen element is formed to form a predetermined film. The process of processing the substrate in this modification may be shown as follows. $\begin{matrix}\left(Precursor gas\to gas removal\to reaction gas\to gas removal\right) \times m \\ \to \left(\begin{matrix}Pprecursor gas \to Precursor gas \to Reducing gasl \to Reducing gas \to Gas removal \\ Reaction gas \to Gas removal\end{matrix}\right) \times n \\ ⇒ Predetermined film \left(second layer/first layer \right)\end{matrix}$

In this modification, the processing procedure and the processing condition when the first layer is formed may be, for example, respectively the same as those relating to the supply of the precursor gas, the gas removal, the supply of the reaction gas, and the gas removal in the substrate processing process shown in FIG. 3.

In this modification, since the first layer contains more halogen elements than the second layer, the proportion of crystallites oriented in the predetermined crystal plane becomes lower on the side of the first layer. Further, since at least a portion of the second layer contains crystallites grown in the first layer, the orientation of the second layer tends to be similar to that of the first layer. Therefore, as compared with the first cycle, a film with a low degree of orientation in the predetermined crystal plane can be formed even though the second cycle is performed under the condition that the halogen element contained in the layer is decreased. That is, in this modification, the amount of the halogen element contained in the entire film can be reduced. The electrical properties of the film can thus be improved. Further, in the second cycle, the amount of the halogen element in the layer that is a factor that suppresses adsorption of the precursor gas or the reaction gas is reduced. Thereby, the deposition rate in the second cycle and the entire formation of the film can be improved.

Further, as the second cycle, the cycle shown in FIG. 6 may be performed. Further, as the first cycle, the cycle shown in FIG. 3 may be performed. In these cases, by making at least one of the formation conditions different between the first cycle and the second cycle, the amounts of the halogen elements contained in the first layer and the second layer respectively may be made different from each other. The substrate processing processes in these modifications may be respectively shown as follows. $\begin{matrix}\left(Precursor gas\to gas removal\to reaction gas\to gas removal\right) \times m \\ \to \left(precursor gas\to gas removal\to reactions gas\to gas removal\right) \times n \\ ⇒ Predetermined film \left(second layer/first layer \right)\end{matrix}$ $\begin{matrix}\left(\begin{matrix}Precursor Gas \to Precursor Gas \to Reducing Gas \to Reducing Gas \to Gas removal \to \\ Reaction gas \to Gas removal\end{matrix}\right) \times m \\ \to \left(\begin{matrix}Precursor gas \to Precursor gas \to Reducing gas \to Reducing gas \to Gas removal \\ Reaction gas \to Gas removal\end{matrix}\right) \times n \\ ⇒ Predetermined film \left(second layer/first layer \right)\end{matrix}$

Further, after formation of a layer with a small content of the halogen element on the wafer 200, a layer with a large content of the halogen element may be formed, such that a predetermined film may be formed. Also in this modification, at least some of the above-described effects are obtained. Further, in the formation of the film, the formation condition may be changed two or more times, and the formation condition may be continuously changed every cycle. Even in this case, at least some of the above-described effects are obtained.

Further, for example, the orientation of the formed film may be controlled based on at least one selected from the group of the number of times (m times) the first cycle is performed, the number of times (n times) the second cycle is performed, a ratio of n to m (n/m), and a ratio of m to n (m/n). Even in such a case, at least some of the above-described effects are obtained. Further, at least one selected from the group of m, n, n/m, and m/n may be included in the above-described formation conditions.

For example, as compared with a conventional condition, in a case where m is increased and n is decreased (i.e., n/m is decreased and m/n is increased), the amount of the halogen element contained in the layer can be made larger than that under the conventional condition. Therefore, it is possible to form a film with a lower degree of orientation in a predetermined crystal plane than the conventional condition.

### (Third Modification)

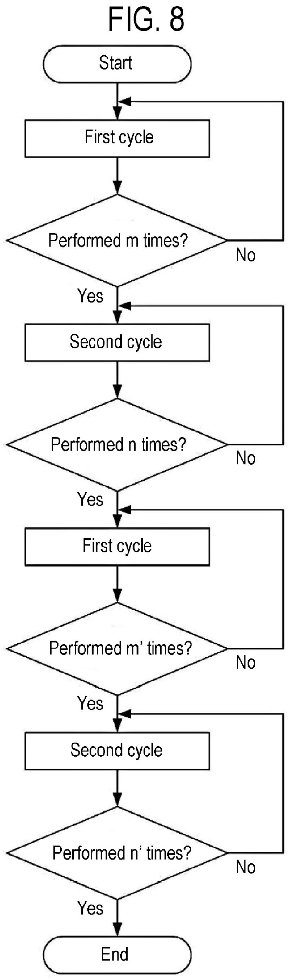

In this modification, m, n, n/m, and m/n in the above-described second modification are changed at least once during the formation of the film. FIG. 8 shows a flow of substrate processing in this modification. In this modification, a step of performing the first cycle m times and a step of performing the second cycle n times are performed. Thereby, a third layer is formed on the wafer 200. Then, a fourth layer is formed on the third layer by performing a step of performing the first cycle m' times and a step of performing the second cycle n' times. Hereinafter, a case where m > m' and n < n' will be described as an example. The process of processing the substrate in this modification may be shown as follows. $\begin{matrix}\left(Precursor gas\to gas removal\to reaction gas\to gas removal\right) \times m \\ \to \left(\begin{matrix}Precursor gas \to Precursor gas \to Reducing gas \to Reducing gas \to Gas removal \to \\ Reaction gas \to Gas removal\end{matrix}\right) \times n \\ \to \left(precursor gas\to gas removal\to reaction gas\to gas removal\right) \times m ′ \\ \to \left(\begin{matrix}Precursor Gas \to Precursor Gas \to Reducing Gas \to Reducing Gas \to Gas \\ Removal \to Reaction Gas \to Gas removal\end{matrix}\right) \times n ′ \\ ⇒ Predetermined film \left(fourth layer/thyrd layer \right)\end{matrix}$

In the step of forming the third layer, the number of times the first cycle is performed is larger and the number of times the second cycles is performed is smaller than in the step of forming the fourth layer. For this reason, the amount of the halogen element contained in the third layer is larger than the amount of the halogen element contained in the fourth layer. In other words, after the third layer with a large content of the halogen element is formed on the wafer 200, the fourth layer having a small content of the halogen element is formed, such that a predetermined film is formed.

In this case, as described in the second modification, since at least a portion of the fourth layer contains the crystallites grown in the third layer, the orientation of the fourth layer tends to be similar to that of the third layer. Therefore, the same effects as those of the second modification can also be obtained in this modification.

Further, the first cycle may not be performed in the formation of the third layer or the formation of the fourth layer, or the second cycle may not be performed in the formation of the third layer or the formation of the fourth layer. That is, m or m' may be zero, and n or n' may be zero.

### (4) Other Embodiments of the present disclosure

In the above-described embodiments and modifications, the case where the gas containing no main constituent element of the film is used as the reducing gas is described as an example. However, the present disclosure is not limited thereto. As the reducing gas, for example, a gas containing a main constituent element of a film and containing a molecular structure different from that of a reaction gas may be used. For example, in a case where the reaction gas is a nitriding gas, a nitriding gas among the above-described nitriding gas containing a molecular structure different from that of the reaction gas may be used as the reducing gas.

Further, in the above-described embodiments and modifications, examples in which the film formation is performed by using a batch-type substrate processing apparatus configured to process a plurality of wafers 200 at a time are described. The present disclosure is not limited to the above-described embodiments, but may also be suitably applied to a case where the film formation is performed by using, for example, a single-wafer substrate processing apparatus configured to process one or several wafers 200 at a time. In addition, in the above-described embodiments, examples in which the film formation is performed by using a substrate processing apparatus including a hot-wall-type process furnace are described. The present disclosure is not limited to the above-described embodiments, but may also be suitably applied to a case where the film formation is performed by using a substrate processing apparatus including a cold-wall-type process furnace.

Even when such substrate processing apparatuses are used, each process may be performed by using the same processing sequences and process conditions as the above-described embodiments and modifications, and the same effects as the above-described embodiments and modifications may be obtained.

The above-described embodiments and modifications may be used in combination as appropriate. Processing procedures and processing conditions in such a case may be similar to, for example, the processing procedures and the processing conditions of the above-described embodiments and modification.

### EXPLANATION OF REFERENCE NUMERALS

200: Wafer (substrate)

## Claims

1. A method of processing a substrate, comprising:
forming a film on the substrate by performing a cycle a predetermined number of times, the cycle comprising:
forming a layer on the substrate by performing a process, which includes:
(a) supplying a precursor gas containing a halogen element to the substrate; and
(b) supplying a reaction gas to the substrate,
wherein the cycle is performed under a formation condition set based on a predetermined relationship between an amount of the halogen element contained in the layer and a proportion of crystallites oriented in a predetermined crystal plane in the film.

2. The method of Claim 1, wherein the amount of the halogen element contained in the layer is changed by changing the formation condition at least once in the act of forming the film.

3. The method of Claim 2, wherein the amount of the halogen element contained in the layer formed after changing the formation condition is less than the amount of the halogen element contained in the layer formed before changing the formation condition.

4. The method of Claim 2, wherein the cycle includes a first cycle and a second cycle,
wherein a formation condition for the second cycle is set such that an amount of the halogen element contained in the layer formed in the second cycle is different from an amount of the halogen element contained in the layer formed in first second cycle, and
wherein the proportion is controlled based on at least one selected from the group of the number of times m the first cycle is performed, the number of times n the second cycle is performed, n/m, which is a ratio of n to m, and m/n, which is a ratio of m to n.

5. The method of Claim 4, wherein at least one selected from the group of m, n, n/m, and m/n is changed at least once in the act of forming the film.

6. The method of any one of Claims 1 to 5, wherein the formation condition includes one or both of an exposure amount of the precursor gas in (a) and an exposure amount of the reaction gas in (b).

7. The method of any one of Claims 1 to 5, wherein the act of forming the film further includes:
(c) supplying a reducing gas to the substrate.

8. The method of Claim 7, wherein the reducing gas does not contain a main constituent element of the film.

9. The method of Claim 8, wherein (c) is performed at least partially at the same time as (a).

10. The method of Claim 9, wherein the formation condition includes a length of a period in which (a) and (c) are performed at the same time.

11. The method of Claim 8, wherein (c) starts at the same time as an end of (a).

12. The method of Claim 7, wherein the formation condition includes at least one selected from the group of an exposure amount of the precursor gas in (a), an exposure amount of the reaction gas in (b), and an exposure amount of the reducing gas in (c).

13. The method of any one of Claims 1 to 5, wherein the act of forming the film further includes:
(d) performing gas removal in a space in which the substrate exists, and
wherein the formation condition includes a condition of the gas removal.

14. The method of Claim 13, wherein the condition of the gas removal includes at least one selected from the group of a time for performing the gas removal, an internal pressure of the space during the gas removal, and a supply flow rate of a purge gas during the gas removal.

15. The method of Claim 7, wherein the reducing gas contains a main constituent element of the film and contains a molecular structure different from a molecular structure of the reaction gas.

16. The method of any one of Claims 1 to 5, wherein the film is a titanium nitride film.

17. The method of Claim 16, wherein the predetermined crystal plane is a {111} plane in a crystal lattice of titanium nitride.

18. A method of manufacturing a semiconductor device, comprising:
forming a film on the substrate by performing a cycle a predetermined number of times, the cycle comprising:
forming a layer on the substrate by performing a process, which includes:
(a) supplying a precursor gas containing a halogen element to the substrate; and
(b) supplying a reaction gas to the substrate,
wherein the cycle is performed under a formation condition set based on a predetermined relationship between an amount of the halogen element contained in the layer and a proportion of crystallites oriented in a predetermined crystal plane in the film.

19. A program that causes, by a computer, a substrate processing apparatus to perform a process comprising:
forming a film on a substrate by performing a cycle a predetermined number of times, the cycle comprising:
forming a layer on the substrate by performing a method, which includes:
(a) supplying a precursor gas containing a halogen element to the substrate; and
(b) supplying a reaction gas to the substrate,
wherein the cycle is performed under a formation condition set based on a predetermined relationship between an amount of the halogen element contained in the layer and a proportion of crystallites oriented in a predetermined crystal plane in the film.

20. A substrate processing apparatus, comprising:
a gas supply system configured to supply a precursor gas containing a halogen element and a reaction gas to a substrate; and
a controller configured to be capable of controlling the gas supply system so as to perform a process including:
forming a film on the substrate by performing a cycle a predetermined number of times, the cycle comprising:
forming a layer on the substrate by performing a method, which includes:
(a) supplying the precursor gas to the substrate; and
(b) supplying the reaction gas to the substrate,
wherein the cycle is performed under a formation condition set based on a predetermined relationship between an amount of the halogen element contained in the layer and a proportion of crystallites oriented in a predetermined crystal plane in the film.
